# EUROPÄISCHE PATENTSCHRIFT

(11) **EP 1 643 650 B1**
(45) Veröffentlichungstag und Bekanntmachung des Hinweises auf die Patenterteilung: **05.03.2008**
(21) Anmeldenummer: 05108645.2
(22) Anmeldetag: 20.09.2005
(51) Int. Cl.: H03M 1/10

(54) **Verfahren und Anordnung zum Analog/Digital-Wandeln**
Method and arrangement for analogue-to-digital conversion
Procédé et appareil pour la conversion analogique-numérique

(30) Priorität: 30.09.2004 DE 102004048194
(43) Veröffentlichungstag der Anmeldung: 05.04.2006
(73) Patentinhaber: ROBERT BOSCH GMBH, 70442 Stuttgart (DE)
(72) Erfinder: Tschentscher, Harald, 71723, Grossbottwar (DE); Fehrenbacher, Berthold, 71706, Markgroeningen (DE); Wenzel-Benner, Christian, 71717, Beilstein (DE)

(56) Entgegenhaltungen:
- US-B1- 6 396 426

## Beschreibung

Die Erfindung betrifft ein Verfahren zum Betreiben einer Wandleranordnung zum Analog/Digital-Wandeln sowie eine Wandleranordnung zum Ausführen des Verfahrens.

### Stand der Technik

Bei bekannten Wandleranordnungen zum Analog-Digital-Wandeln werden von Nutzsignalquellen ausgegebene Nutzsignale in wenigstens einen Analog/Digital-Wandler der Wandleranordnung eingegeben und von diesem in eine Folge von Digitalwerten gewandelt. In der Praxis kann es vorkommen, dass Verbindungsleitungen auf einer Strecke zwischen der Nutzsignalquelle und der Wandleranordnung schadhaft sind oder unterbrochen werden, so dass das analoge Nutzsignal die Wandleranordnung nicht erreicht, so dass die von dem Wandler ausgegebenen Digitalwerte nicht dem Nutzsignal entsprechen. Es ist daher notwendig, diese Verbindungsleitungen zu überprüfen.

Bekannte Verfahren zur Überprüfung der Verbindungsleitung zwischen einer Nutzsignalquelle und der Wandleranordnung setzen eine Störsignalquelle mit einem hohen Innenwiderstand ein, die einen Störsignalpegel erzeugt und ausgibt. Der Störsignalpegel wird dem Nutzsignal überlagert, wodurch ein Überlagerungssignal erhalten wird, das in der Wandleranordnung in ein Digitalsignal gewandelt wird. Dabei wird der Störsignalpegel außerhalb eines vorbekannten oder vorgegebenen Intervalls möglicher Nutzsignalpegel gewählt.

Der Innenwiderstand der Störsignalquelle wird dabei wesentlich größer gewählt als der Innenwiderstand der Nutzsignalquelle, so dass im normalen Betrieb der Wandleranordnung, wenn die Verbindungsleitung zur Nutzsignalquelle fehlerfrei ist, das Störsignal das Nutzsignal nicht merklich verfälscht und infolgedessen das Ergebnis der Wandlung des Überlagerungssignals in dem Analog-Digital-Wandler sich nicht oder nicht wesentlich von dem unterscheidet, das auch bei Wandeln des reinen, nicht überlagerten Nutzsignals erhalten würde.

Liegt dagegen eine Störung oder Unterbrechung in der Verbindungsleitung zwischen Nutzsignalquelle und Wandleranordnung vor, so erreicht das Nutzsignal den Wandler nicht und statt des Überlagerungssignals wird lediglich der reine, nicht überlagerte Störsignalpegel vom Analog/Digital-Wandler gewandelt. Weil dieser jedoch entweder oberhalb oder unterhalb des Intervalls der möglichen Pegel des Nutzsignals liegt, ist ein Fehler in der Verbindungsleitung anhand des Zahlenwerts des Wandlungsergebnisses erkennbar.

Ein derartiges Verfahren ist z.B. bekannt aus dem Patentschrift US 6,396,426 B1, welcher ein Verfahren zum Betreiben einer Wandleranordnung zum Analog/Digital-Wandeln beschreibt, bei dem einem von einer Nutzsignalquelle mit niedrigem Innenwiderstand ausgegebenen zu wandelnden analogen Nutzsignal ein von einer Störsignalquelle mit hohem Innenwiderstand ausgegebener Störsignalpegel überlagert und dadurch ein Überlagerungssignal erhalten wird, das Überlagerungssignal in einem Analog/Digital-Wandler in einen Digitalwert gewandelt wird, festgestellt wird, ob der Digitalwert eine vorgegebene Grenze überschreitet oder nicht, und eine Fehlermeldung über einen Fehler in einer Verbindung zwischen der Nutzsignalquelle und dem Analog/Digital-Wandler ausgegeben wird, wenn ein Überschreiten der vorgegebenen Grenze festgestellt wird.

Ein Nachteil dieser Technik ist, dass das Intervall der Nutzsignalpegel kleiner sein muss als das von dem Wandler korrekt verarbeitbare Pegelintervall. Die Auflösung des Wandlers wird daher unter normalen Betriebsbedingungen nicht optimal ausgenutzt. Außerdem können zusätzliche Schaltungselemente erforderlich sein, um zu gewährleisten, dass das dem Wandler zugeführte Nutzsignal jederzeit strikt innerhalb des zugelassenen Intervalls liegt.

### Vorteile der Erfindung

Durch die vorliegende Erfindung wie in Anspruch 1 bzw. 8 definiert werden ein Verfahren zum Betreiben einer Wandleranordnung zum Analog/Digital-Wandeln sowie eine Wandleranordnung zur Ausführung des Verfahrens geschaffen, bei denen Verbindungsleitungen zwischen Nutzsignalquellen und der Wandleranordnung auch dann überprüfbar sind, wenn das Nutzsignal keinen Einschränkungen hinsichtlich zulässiger Pegel unterliegt, d.h., wenn es jeden Pegel annehmen kann, den der Wandler korrekt zu wandeln im Stande ist. Darüber hinaus darf das Nutzsignal zeitweilig auch Pegel annehmen, die in beide Richtungen über das Intervall der korrekt wandelbaren Pegel hinausreichen, was eine eventuelle Vorverarbeitung des analogen Nutzsignals vor dem Wandeln vereinfacht.

Eine Wandleranordnung zur Durchführung des Verfahrens gemäß der Erfindung kann zwei oder mehr Analog/Digital-Wandler aufweisen, von denen z. B. einer das mit dem ersten Störsignalpegel überlagerte Nutzsignal und der zweite das mit dem zweiten Störsignalpegel überlagerte Nutzsignal empfängt. Wenn beide zur gleichen Zeit empfangene Überlagerungssignalpegel wandeln, ist ein Ausfall des Nutzsignals unmittelbar an einer Diskrepanz der Wandlungsergebnisse erkennbar.

Um die Wandleranordnung einfach und preiswert zu halten, wird vorzugsweise nur ein Analog/Digital-Wandler eingesetzt, der im Wechsel durch Überlagern mit dem ersten bzw. dem zweiten Störsignalpegel erhaltene Überlagerungssignalpegel wandelt.

Die Übergangszeit, die das Nutzsignal benötigt, um von einem der beiden Störsignalpegel zum anderen überzugehen, ist im Allgemeinen von Null verschieden. Vorzugsweise werden daher die zwei Überlagerungssignale nacheinander und innerhalb einer Zeitspanne ausgeführt, die kürzer ist als besagte Übergangszeit. Wenn unter diesen Bedingungen die Differenz zwischen dem ersten und dem zweiten Digitalwert die Grenze überschreitet, kann die Ursache dafür nur ein Ausbleiben des Nutzsignals infolge defekter Leitungen sein, nicht aber eine Änderung des Pegels des Nutzsignals. Auf diese Weise werden fälschliche Fehlermeldungen vermieden.

Die Fehlermeldung kann grundsätzlich an eine dafür zuständige Schaltungskomponente wie z.B. eine Steuereinheit direkt übergeben werden. Sie kann aber auch zunächst in ein Fehlerregister eingetragen werden, aus der sie zu beliebigen späteren Zeiten von der Schaltungskomponente bei Bedarf ausgelesen werden kann.

Bei einer bevorzugten Ausführung wird das erfindungsgemäße Verfahren mit Aufnahme des Betriebs des Analog/Digital-Wandlers ausgeführt. Dies ist insbesondere dann von Vorteil, wenn eine initiale Überprüfung der Verbindungsleitungen bei Aufnahme des Betriebs der Wandleranordnung ausreichend ist. Um eine permanente Überwachung während des Betriebs der Wandleranordnung zu gewährleisten, kann das erfindungsgemäße Verfahren auch vorteilhaft zyklisch während des Betriebs des Analog/Digital-Wandlers ausgeführt werden.

Um irrtümliche oder vorschnelle Fehlermeldungen, die beispielsweise auf Rauscheffekte in den Nutzsignalen zurückzuführen sind, zu vermindern, kann vorgesehen sein, dass die Fehlermeldung im Schritt (f) des Anspruchs 1 erst dann ausgegeben wird, wenn bei wiederholter Ausführung der Schritte (a) bis (e) des Anspruchs 1 bei einer vorgegebenen Anzahl aufeinanderfolgender Ausführungen des Schrittes (e) festgestellt wird, dass die Differenz die Grenze überschreitet.

Eine erfindungsgemäße Wandleranordnung kann bevorzugt einen Speicher umfassen, der die Digitalwerte speichert, sofern die Digitalwerte von nachfolgenden Schaltungskomponenten nicht sofort benötigt werden. Somit können die Digitalwerte je nach Bedarf aus dem Speicher ausgelesen werden.

Ebenso kann ein Fehlerregister zum Speichern der Fehlermeldung in der Wandleranordnung vorgesehen sein, wenn der Komparator feststellt, dass die Differenz zwischen den Digitalsignalen eine vorgegebene Grenze überschreitet. Dies ist insbesondere dann von Vorteil, wenn in den nachfolgenden Schaltungskomponenten aus unvorhergesehenen Gründen Datenverluste eintreten können. In solchen Fällen können die Digitalsignale bzw. die Fehlermeldungen jederzeit erneut aus dem Speicher bzw. dem Fehlerregister ausgelesen werden.

### Zeichnung

Die Erfindung wird im Folgenden anhand bevorzugter Ausführungsformen mit Hilfe von in der Zeichnung dargestellten Figuren näher erläutert.

Es zeigen:
- Fig. 1: ein Prinzipschaltbild für eine erfindungsgemäße Wandleranordnung; und
- Fig. 2: ein Spannungs-Zeitdiagramm.

### Beschreibung der Ausführungsbeispiele

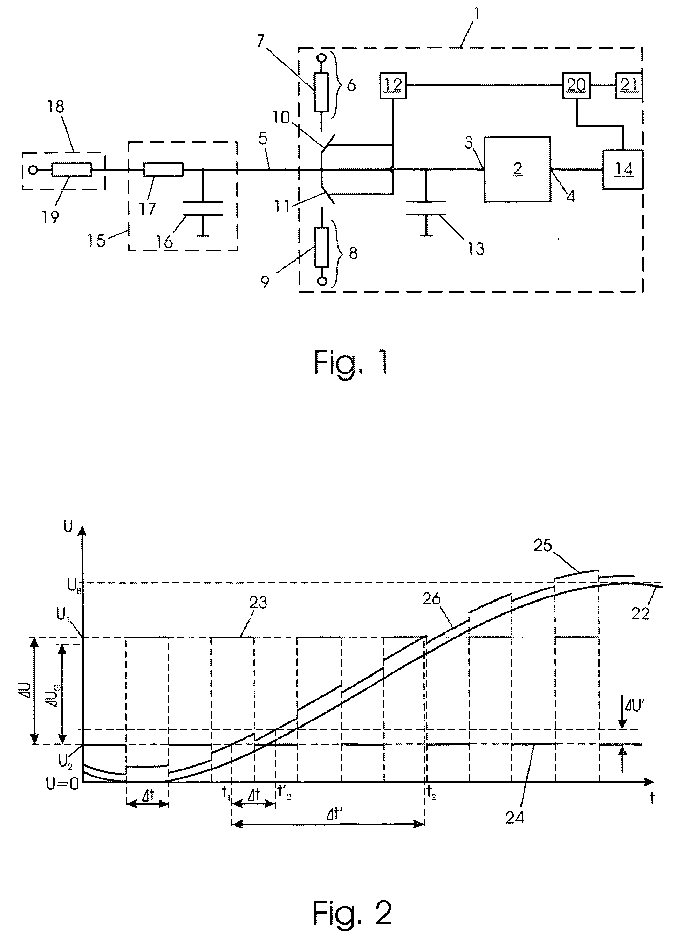

Eine erfindungsgemäße Wandleranordnung 1 ist in der Fig. 1 gezeigt. Herzstück der Wandleranordnung 1 ist ein Analog/Digital-Wandler 2 mit einem Eingang 3 und einem Ausgang 4. In den Eingang 3 mündet eine die Wandleranordnung 1 mit einer externen Nutzsignalquelle 18 verbindende Verbindungsleitung 5. Die Nutzsignalquelle 18 weist einen geringen Innenwiderstand 19 von wenigen Ohm auf. Zwischen der Wandleranordnung 1 und der Nutzsignalquelle 18 ist in der Verbindungsleitung 5 ein Tiefpass 15 vorgesehen, der aus einem Kondensator 16 und einem Widerstand 17 gebildet ist.

Zur Wandleranordnung 1 gehören außer dem Analog/Digital-Wandler 2 zwei Störsignalquellen 6 und 8, zwei Schalter 10 und 11, eine Steuereinheit 12, ein Kondensator 13, ein Speicher 14, ein Komparator 20 und ein Fehlerregister 21. Von den beiden Störquellen 6, 8 weist eine erste Störsignalquelle 6 einen Innenwiderstand 7 auf, während die zweite Störsignalquelle 8 einen Innenwiderstand 9 aufweist. Die beiden Innenwiderstände 7, 9 sind von der Größenordnung von ungefähr 500 kΩ. Mit dem Schalter 10 kann die erste Störsignalquelle 6 wahlweise mit der Verbindungsleitung 5 verbunden werden, während die Störsignalquelle 8 mit dem Schalter 11 wahlweise mit der Verbindungsleitung 5 verbunden werden kann. Betätigt werden die Schalter 10, 11 von der Steuereinheit 12.

Der Kondensator 13 ist mit einem ersten Anschluss zwischen den Störquellen 6, 8 und dem Eingang 3 des Analog/Digital-Wandlers 2 mit der Verbindungsleitung 5 verbunden und mit einem zweiten Anschluss auf Masse gezogen. Ein Eingang des Speichers 14 ist mit dem Ausgang 4 des Analog/Digital-Wandlers 2 verbunden. Ein Ausgang des Speichers 14 ist an einen ersten Eingang des mit der Steuereinheit 12 verbundenen Komparator 20 angeschlossen, an einen Ausgang des Komparators 20 ist das Fehlerregister 21 angeschlossen.

Von der Nutzsignalquelle 18 wird ein zu wandelndes analoges Nutzsignal erzeugt und auf die Verbindungsleitung 5 gelegt. Es durchläuft den Tiefpassfilter 15, woraufhin es in die Wandleranordnung 1 gelangt. Gleichzeitig steuert die Steuereinheit 12 die Schalter 10, 11 derart, dass die Störsignalquellen 6, 8 abwechselnd mit der Verbindungsleitung 5 verbunden werden und dadurch abwechselnd jeweils von ihnen erzeugte Störsignalpegel dem Nutzsignal auf der Verbindungsleitung 5 zu einem jeweiligen Überlagerungssignal überlagert werden. Dabei sind die von den Störsignalquellen 6, 8 erzeugten Störsignalpegel jeweils voneinander verschieden. Diese Überlagerungssignale bewirken zunächst eine abwechselnde Aufladung des Kondensators 13, wodurch eine Stabilisierung der Überlagerungssignale auf der Verbindungsleitung 5 erreicht wird, bevor sie durch den Eingang 3 des Analog/Digital-Wandlers 2 in den Analog/Digital-Wandler 2 gelangen und dort von diesem in Digitalwerte gewandelt werden. Die Digitalwerte werden vom Analog/Digital-Wandler 2 durch den Ausgang 4 ausgegeben und im Speicher 14 gespeichert. Aus dem Speicher 14 können die Digitalwerte von nachfolgenden, hier nicht gezeigten, und dafür zuständigen Schaltungskomponenten nach Bedarf ausgelesen werden.

Die Steuereinheit 12 steuert den Komparator 20 derart, dass er jeweils Paare von ersten und zweiten Digitalsignalen, die jeweils unmittelbar aufeinanderfolgend erzeugt wurden, aus dem Speicher 14 ausliest und miteinander vergleicht. Dazu bildet der Komparator 20 zunächst die Differenz zwischen den beiden Digitalsignalen, und wenn diese Differenz eine vorgegebene Grenze überschreitet, wird vom Komparator 20 eine Fehlermeldung ausgegeben, die im Fehlerregister 21 gespeichert wird. Aus dem Fehlerregister 21 kann diese Fehlermeldung nach Bedarf von nachfolgenden Schaltungskomponenten ausgelesen werden.

Um den Effekt der Überlagerung der jeweiligen Störsignalpegel mit dem Nutzsignal zu verdeutlichen, sowie um die Situation bei Unterbrechung der Verbindungsleitung 5 zwischen der Wandleranordnung 1 und dem Tiefpass 15 bzw. der Nutzsignalquelle 18 zu verdeutlichen, zeigt die Fig. 2 ein Spannungs-Zeitdiagramm, in dem unter anderem das Nutzsignal 22 sowie die beiden auf der Verbindungsleitung 5 anliegenden Störsignalpegel 23 und 24 eingetragen sind. Dabei markiert U_{B} eine obere und U=0 eine untere Grenze für Spannungswerte, die ein Signal annehmen darf, um von dem Analog/Digital-Wandler 2 korrekt gewandelt werden zu können, und denen jeweils Digitalisierungsergebnisse 0 zu 2ⁿ-1 entsprechen (wenn n die Zahl der Bits der vom Analog/Digital-Wandler 2 ausgegebenen Digitalwerte ist). Alle Spannungswerte zwischen U_{B} und U=0 bilden somit den Nutzbereich des Analog/Digital-Wandlers 2.

Zwischen der oberen Grenze U_{B} und dem Wert U=0 kann das zeitlich veränderliche Nutzsignal 22 im Laufe der Zeit t jeden Spannungspegel annehmen. Die Geschwindigkeit, mit der das Nutzsignal 22 seinen Pegel ändern kann, ist durch den Tiefpassfilter 15 begrenzt.

Von der Steuereinheit 12 werden die Schalter 10, 11 jeweils nach Verstreichen der Zeitspanne Δt umgeschaltet, so dass die in Fig. 2 eingezeichneten Störsignalpegel 23, 24 abwechselnd während gleich langer Zeitspannen Δt auf der Verbindungsleitung 5 anliegen. Die beiden Störsignalpegel 23, 24 können daher auch als ein einziges Störsignal mit rechteckig oszillierendem Verlauf aufgefasst werden. In Fig. 2 sind die Störsignalpegel 23, 24 als reine, nicht überlagerte Signale zu sehen, was dem Fall einer Unterbrechung der Verbindungsleitung 5 entspricht. Den beiden Störsignalpegeln 23, 24 entsprechen jeweils konstante Spannungswerte U₁ und U₂ zum Überlagern mit dem Nutzsignal 22, wobei der Spannungswert U₁ des ersten Störsignalpegels höher als der Spannungswert U₂ des zweiten Störsignalpegels 24 ist. Beide Spannungswerte U₁ und U₂ befinden sich jedoch innerhalb des Nutzbereiches zwischen U_{B} und U=0 des Analog/Digital-Wandlers 2.

Im regulären Betrieb ist die Verbindungsleitung 5 nicht unterbrochen, d.h., das Nutzsignal 22 gelangt in die Wandleranordnung 1. In der Wandleranordnung 1 wird das Nutzsignal 22 abwechselnd mit einem der von den Störspannungsquellen 6, 8 erzeugten Störsignalpegel 23, 24 überlagert. Im Diagramm der Fig. 2 sind auch die aus diesen Überlagerungen resultierenden Überlagerungssignalpegel 25, 26 eingezeichnet. Aus der Überlagerung des Nutzsignals 22 mit dem Störsignalpegel 23 resultiert der Überlagerungssignalpegel 25, aus der Überlagerung des Störsignalpegels 24 mit dem Nutzsignal 22 der Überlagerungssignalpegel 26. Das Eingangssignal des Analog/Digital-Wandlers 2 setz sich jeweils Stückweise aus den Überlagerungssignalen 25 und 26 zusammen.

In der Fig. 2 sind die Überlagerungssignale 25, 26 zur Verdeutlichung des Sachverhalts von dem Nutzsignal 22 übertrieben beabstandet eingezeichnet. Weil die Innenwiderstände 7, 9 der Störsignalquellen 6, 8 im Bereich von 500 kΩ liegen während der Innenwiderstand 19 der Nutzspannungsquelle 18 lediglich einige Ohm beträgt, ist der Spannungsunterschied zwischen den Signalen 22, 25, 26 in Wirklichkeit sehr gering. In der Praxis ist er vorzugsweise kleiner als die Auflösung des Analog/Digital-Wandlers 2, so dass das erste und das zweite Überlagerungssignal 25 bzw. 26 zumeist gleiche Wandlungsergebnisse liefern.

Weil sich die Überlagerungssignale 25, 26 langsam ändern und dabei im Laufe der Zeit alle Spannungswerte zwischen U_{B} und U=0 annehmen, gibt es Zeiten, zu denen auch die Spannungen U₁ und U₂ der Störsignalpegel 23, 24 von ihnen angenommen werden. Beispielsweise nimmt das Überlagerungssignal 25 in der Figur 2 zur Zeit t₁ den Spannungswert U₂ des Störsignalpegels 24 an, so dass der am Eingang des Analog/Digital-Wandlers 2 anliegende Spannungspegel nicht von dem Pegel zu unterscheiden ist, der bei einer Unterbrechung der Leitung 5 anläge. Infolge der begrenzten Änderungsrate des Nutzsignals dauert es bis zur Zeit t₂, bis eines der anwachsenden Überlagerungssignale 25, 26 frühestens den Spannungspegel U₁ erreicht, der dem ersten Störsignalpegel 23 entspricht. Die zwischen den Zeitpunkten t₁ und t₂ liegende Zeitspanne Δt' ist daher wesentlich länger als die Zeitspanne Δt, nach der zwischen den Störsignalpegeln 23, 24 umgeschaltet wird. Wegen der ausreichend kleinen Zeitspanne Δt wird somit ausgeschlossen, dass sich die Überlagerungssignale 25, 26 innerhalb der kurzen Zeitspanne Δt derart verändern, dass sie innerhalb dieser Zeit einmal den Spannungswert U₁ und einmal den Spannungswert U₂ annehmen, oder anders ausgedrückt, weil die Ableitung dU(t)/dt der Kurve für das Nutzsignal 22 nach der Zeit t dafür zu klein ist.

Hieraus erklärt sich, woran der Komparator 20 eine Unterbrechung der Verbindungsleitung 5 erkennt: Wie oben erläutert wurde, vergleicht der Komparator 20 Digitalsignale, die nach Wandeln zweier unmittelbar aufeinanderfolgender Überlagerungssignale 25, 26 erhalten werden. Die Überlagerungssignale 25, 26 folgen im zeitlichen Abstand von Δt aufeinander. Der Einfachheit halber sei angenommen, dass der Komparator 20 das nach Wandeln des Überlagerungssignals 25 zum Zeitpunkt t₁ erhaltene Digitalsignal mit demjenigen Digitalsignal vergleicht, das um Δt später zum Zeitpunkt t₂' nach Wandeln des jeweiligen Überlagerungssignals 26 erhalten wird. Der Vergleich besteht im Ermitteln der Differenz zwischen diesen Digitalsignalen. Diese Differenz entspricht der in Fig. 2 eingezeichneten Spannungsdifferenz ΔU'.

Wenn die Verbindungsleitung 5 unterbrochen ist und das Nutzsignal 22 nicht mehr in die Wandleranordnung 1 gelangt und keine Überlagerungssignale 25, 26 erzeugt werden, sondern statt dessen die Störsignalpegel 23, 24 jeweils nicht überlagert vom Analog/Digital-Wandler 2 gewandelt werden, dann wird zum Zeitpunkt t₁ der Spannungspegel U₁ des nicht überlagerten Störsignals 23 und zum Zeitpunkt t₂' der Spannungspegel U₂ des nicht überlagerten Störsignals 24 gewandelt. Die vom Komparator 20 ermittelte Differenz zwischen den Wandelergebnissen zu den Zeitpunkten t₁ und t₂' entspricht jetzt der wesentlich größeren Spannungsdifferenz ΔU zwischen den beiden Spannungspegeln U₁ und U₂ der nicht überlagerten Störsignale 23 und 24. Um allfällige Rauscheffekte der Signale auszuschließen, ist dem Komparator 20 eine Grenze ΔU_{G} vorgegeben, deren Betrag knapp unterhalb dem Betrag der Differenz ΔU zwischen den Spannungen U₁ und U₂ gewählt ist. Die Ausgabe der Fehlermeldung in das Fehlerregister 21 durch den Komparator 20 erfolgt dabei erst dann, wenn die vom Komparator 20 ermittelte Differenz zwischen den Digitalsignalen diese Grenze ΔU_{G} überschreitet.

Anhand des Auftretens der die Grenze ΔU_{G} überschreitenden Spannungsdifferenz ΔU erkennt der Komparator 20 also die Fehlerhaftigkeit der Verbindungsleitung 5, weil im Falle der fehlerfreien Verbindungsleitung 5 eine so große Spannungsdifferenz ΔU wegen der viel zu geringen Änderungsrate der Überlagerungssignale 25, 25 innerhalb der ausreichend kurz gewählten Zeitspanne Δt niemals auftreten kann.

## Patentansprüche

1. Verfahren zum Betreiben einer Wandleranordnung zum Analog/Digital-Wandeln, bei dem
(a) einem von einer Nutzsignalquelle (18) mit niedrigem Innenwiderstand (19) ausgegebenen zu wandelnden analogen Nutzsignal (22) ein von einer Störsignalquelle (6, 8) mit hohem Innenwiderstand (7, 9) ausgegebener erster Störsignalpegel (23, 24) überlagert und dadurch ein erstes Überlagerungssignal (25, 26) erhalten wird,
(b) das erste Überlagerungssignal in einem Analog/Digital-Wandler (2) in einen ersten Digitalwert gewandelt wird;
**dadurch gekennzeichnet, dass**
(c) dem analogen Nutzsignal (22) ein von dem ersten Störsignalpegel verschiedener zweiter Störsignalpegel (24, 23) überlagert und dadurch ein zweites Überlagerungssignal (25, 26)erhalten wird,
(d) das zweite Überlagerungssignal in einem Analog/Digital-Wandler (2) in einen zweiten Digitalwert gewandelt wird;
(e) festgestellt wird, ob die Differenz zwischen dem ersten und dem zweiten Digitalwert eine vorgegebene Grenze überschreitet oder nicht;
(f) eine Fehlermeldung über einen Fehler in einer Verbindung zwischen der Nutzsignalquelle (18) und dem Analog/Digital-Wandler (2) ausgegeben wird, wenn ein Überschreiten der vorgegebenen Grenze festgestellt wird.

2. Verfahren nach Anspruch 1, **dadurch gekennzeichnet, dass** die Schritte (a) bis (d) nacheinander unter Verwendung eines einzigen Analog/Digital-Wandlers (2) ausgeführt werden.

3. Verfahren nach Anspruch 2, **dadurch gekennzeichnet, dass** die Schritte (a) bis (d) innerhalb einer Zeitspanne ausgeführt werden, die kürzer ist als die minimale Zeit, die das Nutzsignals (22) benötigt, um von einem der beiden Störsignalpegel (23, 24) zum anderen überzugehen.

4. Verfahren nach einem der vorhergehenden Ansprüche, **dadurch gekennzeichnet, dass** die Fehlermeldung in ein Fehlerregister (21) eingetragen wird.

5. Verfahren nach einem der vorhergehenden Ansprüche, **dadurch gekennzeichnet, dass** die Schritte (a) bis (f) mit Aufnahme des Betriebs des Analog/Digital-Wandlers (2) ausgeführt werden.

6. Verfahren nach einem der vorhergehenden Ansprüche, **dadurch gekennzeichnet, dass** die Schritte (a) bis (f) während des Betriebs des Analog/Digital-Wandlers (2) zyklisch ausgeführt werden.

7. Verfahren nach einem vorhergehenden Ansprüche, **dadurch gekennzeichnet, dass** die Fehlermeldung im Schritt (f) erst dann ausgegeben wird, wenn bei wiederholter Ausführung der Schritte (a) bis (e) bei einer vorgegebenen Anzahl aufeinanderfolgender Ausführungen des Schrittes (e) festgestellt wird, dass die Differenz die Grenze überschreitet.

8. Wandleranordnung (1), insbesondere eine Wandleranordnung (1) zum Ausführen eines Verfahrens nach einem der vorhergehenden Ansprüche, mit einem Eingang, an den eine ein analoges Nutzsignal (22) ausgebende Nutzsignalquelle (18) mit niedrigem Innenwiderstand (19) anschließbar ist, wenigstens einem Analog/Digital-Wandler (2) und einer Störsignalquelle (6, 8) mit hohem Innenwiderstand (7, 9) zum Erzeugen eines vom Analog/Digital-Wandler (2) zu wandelnden ersten Überlagerungssignals (25, 26) durch Ausgeben und Überlagern eines ersten Störsignalpegels (23, 24) mit dem Nutzsignal (22), sowie einem Komparator (20) zum Vergleichen eines durch Wandeln des ersten Überlagerungssignals (25, 26) erzeugten ersten Digitalsignals mit einem zweiten Digitalsignal, **gekennzeichnet durch** eine zweite Störsignalquelle (6, 8) mit hohem Innenwiderstand (7, 9) zum Erzeugen eines von einem der Analog/Digital-Wandler (2) in das zweite Digitalsignal zu wandelnden zweiten Überlagerungssignals (25, 26) **durch** Ausgeben und Überlagern eines von dem ersten Störsignalpegel verschiedenen zweiten Störsignalpegels (23, 24) mit dem Nutzsignal (22).

9. Wandleranordnung (1) nach Anspruch 8, **dadurch gekennzeichnet, dass** sie einen Speicher (14) umfasst, welcher die Digitalsignale speichert.

10. Wandleranordnung (1) nach Anspruch 8 oder 9, **dadurch gekennzeichnet, dass** sie ein Fehlerregister (21) umfasst, welches eine Fehlermeldung speichert, wenn der Komparator (20) feststellt, dass die Differenz zwischen den Digitalsignalen eine vorgegebene Grenze überschreitet.

## Claims

1. Method for operating a converter arrangement for analogue/digital conversion, in which
(a) an analogue useful signal (22) to be converted which is output by a useful signal source (18) with a low internal resistance (19) has a first noise signal level (23, 24), which is output by a noise signal source (6, 8) with a high internal resistance (7, 9), superimposed on it and this produces a first superimposition signal (25, 26),
(b) the first superimposition signal is converted into a first digital value in an analogue/digital converter (2) ;
**characterized in that**
(c) the analogue useful signal (22) has a second noise signal level (24, 23), which is different from the first noise signal level, superimposed on it and this produces a second superimposition signal (25, 26),
(d) the second superimposition signal is converted into a second digital value in an analogue/digital converter (2);
(e) it is established whether or not the difference between the first and the second digital value exceeds a prescribed limit;
(f) an error message about an error in a connection between the useful signal source (18) and the analogue/digital converter (2) is output if it is established that the prescribed limit is exceeded.

2. Method according to Claim 1, **characterized in that** steps (a) to (d) are executed in succession using a single analogue/digital converter (2).

3. Method according to Claim 2, **characterized in that** steps (a) to (d) are executed within a period which is shorter than the minimum time which the useful signal (22) requires in order to cross from one of the two noise signal levels (23, 24) to the other.

4. Method according to one of the preceding claims, **characterized in that** the error message is entered into an error register (21).

5. Method according to one of the preceding claims, **characterized in that** steps (a) to (f) are executed with the exception of operation of the analogue/digital converter (2).

6. Method according to one of the preceding claims, **characterized in that** steps (a) to (f) are executed cyclically during operation of the analogue/digital converter (2).

7. Method according to one of the preceding claims, **characterized in that** the error message is output in step (f) only if, during repeated execution of steps (a) to (e), it is established for a prescribed number of successive executions of step (e) that the difference exceeds the limit.

8. Converter arrangement (1), particularly a converter arrangement (1) for carrying out a method according to one of the preceding claims, having an input to which it is possible to connect a useful signal source (18), outputting an analogue useful signal (22), with a low internal resistance (19), at least one analogue/digital converter (2) and a noise signal source (6, 8) with a high internal resistance (7, 9) for producing a first superimposition signal (25, 26), which is to be converted by the analogue/digital converter (2), by outputting and superimposing a first noise signal level (23, 24) with the useful signal (22), and having a comparator (20) for comparing a first digital signal, produced by converting the first superimposition signal (25, 26), with a second digital signal, **characterized by** a second noise signal source (6, 8) with a high internal resistance (7, 9) for producing a second superimposition signal (25, 26), which is to be converted into the second digital signal by one of the analogue/digital converters (2), by outputting and superimposing a second noise signal level (23, 24), which is different from the first noise signal level, with the useful signal (22).

9. Converter arrangement (1) according to Claim 8, **characterized in that** it comprises a memory (14) which stores the digital signals.

10. Converter arrangement (1) according to Claim 8 or 9, **characterized in that** it comprises an error register (21) which stores an error message if the comparator (20) establishes that the difference between the digital signals exceeds a prescribed limit.

## Revendications

1. Procédé de gestion d'un dispositif de conversion pour la conversion analogique/numérique selon lequel
(a) on combine un signal utile (22) analogique, à convertir, fourni par une source de signaux utiles (18) à faible résistance intérieure (19) à un premier niveau de signal parasite (23, 24) émis par une source de signaux parasites (6, 8) à forte résistance intérieure (7, 9) et on obtient ainsi un signal combiné (25, 26),
(b) on convertit le premier signal combiné dans un convertisseur analogique/numérique (2) pour obtenir une première valeur numérique,
**caractérisé en ce que**
(c) on combine au signal utile analogique (22) un second niveau de signal parasite (2, 23) différent du premier niveau de signal parasite et on obtient ainsi un second signal combiné (25, 26),
(d) on convertit le second signal combiné dans un convertisseur analogique/numérique (2) en une seconde valeur numérique,
(e) on détermine si la différence entre la première et la seconde valeur numériques dépasse ou non une limite prédéfinie,
(f) on émet un message de défaut concernant un défaut dans une liaison entre la source de signaux utiles (18) et le convertisseur analogique/numérique (2) si on constate un dépassement de la limite prédéfinie.

2. Procédé selon la revendication 1,
**caractérisé en ce qu'**
on exécute les étapes (a)-(d) successivement en utilisant un unique convertisseur analogique/numérique (2).

3. Procédé selon la revendication 2,
**caractérisé en ce qu'**
on exécute les étapes (a)-(d) au cours d'un intervalle de temps plus court que le temps minimum nécessaire au signal utile (22) pour passer d'un des deux niveaux de signal parasite (23, 24) à l'autre.

4. Procédé selon l'une des revendications précédentes,
**caractérisé en ce qu'**
on enregistre le message de défaut dans un registre de défauts (21).

5. Procédé selon l'une des revendications précédentes,
**caractérisé en ce qu'**
on exécute les étapes (a)-(f) en mettant en oeuvre le fonctionnement du convertisseur analogique/numérique (2).

6. Procédé selon l'une des revendications précédentes,
**caractérisé en ce qu'**
on exécute de manière cyclique les étapes (a)-(f) pendant le fonctionnement du convertisseur analogique/numérique (2).

7. Procédé selon l'une des revendications précédentes,
**caractérisé en ce qu'**
on émet le message de défaut de l'étape (f) seulement si pour une exécution répétée des étapes (a)-(e), pour un nombre prédéfini d'exécutions successives de l'étape (e), on constate que la différence dépasse la limite.

8. Dispositif convertisseur (1), notamment dispositif convertisseur (1) pour exécuter un procédé selon l'une des revendications précédentes ayant une entrée à laquelle peut être reliée une source de signaux utiles (18) émettant un signal utile analogique (22) et ayant une faible résistance interne (19), au moins un convertisseur analogique/numérique (2) et une source de signaux parasites (6, 8) à forte résistance intérieure (7, 9) pour générer un signal de combinaison (25, 26) à convertir par le convertisseur analogique/numérique (2) par l'émission et la combinaison d'un premier niveau de signal parasite (23, 24) au signal utile (22) ainsi qu'un comparateur (20) pour comparer un premier signal numérique généré par la conversion du premier signal de combinaison (25, 26) à un second signal numérique,
**caractérisé par**
une seconde source de signaux parasites (6, 8) à forte résistance intérieure (7, 9) pour générer un second signal de combinaison (25, 26) destiné à être converti par le convertisseur analogique/numérique (2) pour obtenir un second signal de combinaison (25, 26) par l'émission et la combinaison d'un second niveau de signal parasite (23, 24) avec le signal utile (22).

9. Dispositif convertisseur (1) selon la revendication 8,
**caractérisé en ce qu'**
il comprend une mémoire (14) qui mémorise les signaux numériques.

10. Dispositif convertisseur (1) selon les revendications 8 ou 9,
**caractérisé en ce qu'**
il comprend un registre de défauts (21) qui mémorise un message de défaut si le comparateur (20) constate que la différence entre les signaux numériques dépasse une limite prédéfinie.
